# EUROPÄISCHE PATENTANMELDUNG

(11) **EP 2 202 803 A2**
(43) Veröffentlichungstag der Anmeldung: **30.06.2010**
(21) Anmeldenummer: 09175382.2
(22) Anmeldetag: 09.11.2009
(51) Int. Cl.: H01L 31/0296, H01L 27/142

(54) **Wirkungsgradoptimierte CdS/CdTe Module**

(30) Priorität: 13.11.2008 DE 102008057075
(71) Anmelder: Antec Solar GmbH, 99310 Arnstadt (DE)
(72) Erfinder: Wilms, Johann Erich, 58710, Menden (DE)
(74) Vertreter: Englaender, Klaus

(57) **Zusammenfassung**

CdS/CdTe Dünnschicht-Solar-Modul, umfassend auf einer Trägerplatte eine transparente leitfähigen Oxidschicht (TCO), auf dieser TCO-Schicht eine n-leitende CdS-Schicht, auf dieser n-leitenden CdS-Schicht eine CdTe-Absorberschicht, wobei die transparente leitfähige Oxidschicht, eine Stärke von unter 400 nm aufweist, und wobei die n-leitende CdS-Schicht eine Stärke von unter 200 nm aufweist und wobei die CdTe-Abscnberschicht eine Schichtdicke von unter 7 µm aufweist und zur Erhöhung des Wirkungsgrads Antimon aufweist.

## Beschreibung

Die Erfindung betrifft CdS/CdTe Dünnschicht-Solarmodule mit einem verbesserten Wirkungsgrad.

Mit einem theoretischen Wirkungsgrad von 29,7% und der Möglichkeit, Cadmiumtellurid (CdTe) auf verschiedene Weisen sehr einfach und kostengünstig großflächig abzuscheiden, stellen polykristalline Cadmium-Tellurid-Dünnschichtsolarzellen eine aussichtsreiche Alternative zur etablierten ein- und polykristallinen Siliziumsolarzellentechnologie dar.

Bei CdTe- handelt es sich um einen Halbleiter mit direktem Bandabstand, der daher in der Lage ist, Sonnenenergie effizienter in elektrische Energie umzuwandeln als Halbleiter, welche mit indirektem Bandabstand arbeiten.

Der Energieabstand des Halbleitermaterials von üblicherweise 1,45 eV ermöglicht es, mehr Energie aus dem Sonnenspektrum zu gewinnen als mit den zuvor verwendeten Materialien mit geringerem Energieabstand (1,20 eV).

Daher ist das in CdTe Dünnschicht-Solarmodulen verwendete Halbleitermaterial geeignet, Sonnenenergie in elektrische Energie umzuwandeln, wobei jedoch nur etwa 1% des Halbleitermaterials, das für herkömmliche PV-Technologien notwendig ist, verwendet wird.

Bekannt sind in diesem Zusammenhang polykristalline Cdl-xZnxTe Solarzellen, welche einen Wirkungsgrad von of 8,3% aufweisen und basierend auf Glas/ITO/CdS-Substraten mit Hilfe kathodischer Elektrodeposition unter Verwendung eines nichtwässrigen Ethylenglycol-Bads gewonnen werden. Dieser Aufbau ist im Vergleich zum Aufbau von XRD **dadurch gekennzeichnet, dass** eine bevorzugte (1 1 1) Ausrichtung einer Antimon (Sb) Einlagerung in einem Elektro-Bad erzielbar ist. Wirkungen dieser Sb Einlagerung in CdS/Cdl-xZnxTe sind z. B. die Verringerung der Gefahr eines Kurzschlussstroms sowie die Reduktion des Reihenwiderstands (Rs) mit Hilfe dieser Sb-Einlagerungen. Auf diese Weise konnten verbesserte Ergebnisse bei Verwendung von 2×10-3 M ZnC12 in Verbindung mit im Bad enthaltenen Antimon erreicht werden. Unter definierten Bedingungen ergaben sich dabei für die Leerlaufspannung die Kurzschlussstromdichte und den Füllfaktor idealerweise die Werte Voc=600 mV, Jsc=26.66 mA/cm2, FF=0,42 sowie eine Effizienz von η=8.3%. Die Trägerkonzentration und das Potential von Cd1-xZnxTe basierend auf einem Mott-Schottky betrugen hierbei 2.72×1017 cm-3 und 1.02 eV.

Weiterhin ist die Erzeugung einer p-CdTe:Sb Schicht unter einem Argon-Druck von 2,5 m Torr sowie mit einer SubstratTemperatur von 450 °C bekannt. Die CdTe:Sb Schichtdicke lag zwischen 5 -11 µm. Daraufhin wurde diese Struktur wie folgt aktiviert:
(i) nach dem Aufbringen von CdTe wurde die Arbeitstemperatur im Vakuum zwischen 350 - 550 °C variiert und
(ii) die Arbeitstemperatur wurde in einer Ar-Atmosphäre in einem zwischen 400 - 510°C gewählt, nachdem die Heterostruktur in eine CdC12-Lösung eingebracht wurde. Darauf erfolgte die Optimierung des Cu-Au-Kontakts. Die hierdurch erreichte höchste Energieausbeute (η) betrug 5.48%.

Vor diesem Hintergrund wird weiter daran gearbeitet, den Wirkungsgrad noch weiter zu verbessern: Der theoretisch mögliche Wirkungsgrad von 29,7% ist in der Praxis jedoch nicht erreichbar. Gegenwärtig sind Laborzellen einer Effizienz von bestenfalls 16,5% erzielbar. Kommerzielle Module liegen bei einer Effizienz von maximal 10%.

Einer der Gründe für dieses Auseinanderklaffen von in der Praxis erreichbarer Effizient und der rechnerisch maximal möglichen Effizienz liegt in der geringen Dotierbarkeit der CdTe-Absorberschicht.

Während sich beispielsweise Silizium ohne Weiteres p-dotieren lässt, ist dies bei der CdTe-Absorberschicht nicht möglich. Dies führt u. a. zu einer geringeren Leerlaufspannung VOC und darüber hinaus zu einer schlechteren Leitfähigkeit der Ladungsträger.

In diesem Zusammenhang dient das verwendete Fenstermaterial Cadmiumsulfid (CdS) sowohl als n-Leiter im Halbleiterheterokontakt zur Erzeugung der Bandverbiegung als auch als Pufferschicht zum Frontkontakt.

Eine gemeinsame Grenzfläche des Absorbers mit dem Frontkontakt führt jedoch zu einer signifikanten Absenkung der VOC.

Weiterhin ist zu beobachten, dass es in der CdS-Schicht zu einer ungewollten Absorption von Licht oberhalb von 2,4 eV kommt. Die so erzeugten Ladungsträger tragen jedoch nicht zum Photostrom bei. Hierdurch wird ein wichtiger Teil des Sonnenspektrums, welches zur Anregung von Ladungsträgern benötigt wird, bereits im Absorber wegdefiniert.

Darüber hinaus bilden Defekte an der CdS/CdTe-Grenzflache sogenannte Rekombinationszentren, die den theoretisch erreichbaren Photostrom noch weiter verringern.

Aufgabe der Erfindung ist es, den Wirkungsgrad von CdS/CdTe Modulen durch Hinzufügung von Antimon zum CdTE zu erhöhen.

Gelöst wird diese Aufgabe durch die Merkmale des Hauptanspruchs. Erfindungsgemäße Weiterbildungen ergeben sich aus den Unteransprüchen.

Insbesondere wird die Aufgabe gelöst durch ein CdS/CdTe Dünnschicht-Solar-Modul, umfassend eine Schicht Antimon auf der CdTe-Absorberschicht, eine Trägerplatte, darauf angebracht eine transparente leitfähige Oxidschicht (TCO), auf welcher wiederum eine n-leitende CdS-Schicht angebracht ist, wobei auf dieser n-leitenden CdS-Schicht wiederum eine CdTe-Absorberschicht angebracht ist, wobei die transparente leitfähige Oxidschicht- (TCO), eine Stärke von 100 - 400 nm aufweist, wobei die n-leitende CdS--Schicht eine Stärke von 40 - 300 nm aufweist und wobei die CdTe-Absorberschicht eine Schichtdicke von 4 - 8 µm und Antimon (Sb) aufweist.

Da es schwierig ist, p-n Dioden in Cadmiumtellurid (CdTe) zu erzeugen und solche Dioden darüber hinaus eine erhebliche Oberflächenrekombination zeigen würden, wurde bereits 1971 die heute übliche Zellkonfiguration in Form einer p-n Heterodiode gefunden, in der der notwendige p-n Übergang die Form einer Doppelschicht p-CdTe/n-CdS aufweist. CdS wirkt hierbei als "Fenster", da es vom sichtbaren Licht nur einen kleinen Teil im blauen Spektralbereich absorbiert und den Rest zum aktiven CdTe durchläßt. Dort werden dann die Ladungsträger erzeugt.

In Hinblick auf eine kostengünstige Nutzung von Solarenergie haben Dünnschichtsolarzellen, wie die Cadmiumtelluride (CdTe) PV Module, grundlegende Vorteile durch einen geringen Materialverbrauch, eine integrierte Moduldefinition und eine einfachere Massenproduktion. Sie können daher ein Kostenlimit von 0,6 EUR pro Watt bereits bei einer Kapazität von 60 Megawatt pro Jahr erreichen. Aufgrund der hohen Leistungen von Kadmiumtellurid-Dünnschichtsolarzellen die durch schnelle und unempfindliche Prozesse herstellbar sind, zeigt die Technologie ein großes Potential für die industrielle Produktion. Vorliegend wird für Cadmiumtellurid das robuste Verfahren der Close-Spaced-Sublimation (CSS) als Abscheideprozess gewählt, um eine Massenproduktion aufzunehmen.

Aufgrund seiner elementaren physikalisch-chemischen Eigenschaften stellt CdTe ein optimales Material für den Einsatz in Dünnschichtsolarzellen dar. CdTe hat eine Energielücke von 1,45 eV und ist deshalb als Absorber der Sonnenstrahlung spektral sehr gut geeignet. Seine Energielücke ist "direkt", was zu einer extrem hohen Lichtabsorption führt, so dass die verwendeten Schichten nur wenige Mikrometer dick sein müssen, um 90% der möglichen Absorption zu realisieren. Aufgrund der Materialdaten können in CdTe Dünnschichtzellen Stromdichten von 27 mA/cm² und Leerlaufspannungen von fast 0,9 V erwartet werden. Durch die erfindungsgemäßen Maßnahmen ist ferner ein Wirkungsgrad von knapp 12% erzielbar, der durch eine weitere Verfeinerung dieser Maßnahmen auf einen Wirkungsgrad von 18,5% bei zukünftigem Einsatz einer noch ausgereiften Technologie ausbaubar ist.

CdTe-Solarzellen sind typischerweise mit Hilfe einer Superstrat-Schichtung aufgebaut:

Die einzelnen Schichten einer derartigen Zelle werden nacheinander auf einem Trägersubstrat, meist einem Glassubstrat abgeschieden, wobei das Träger;csubstrat in erster Linie der mechanischen Stabilität dient.

Erfahrungsgemäß wird mit der Abscheidung des Frontkontaktes begonnen. Dieser besteht aus einem transparenten leitfähigen Oxid (TCO), welches insbesondere eine Stärke von 100 - 400 nm aufweist. Hierfür ist Indium-Zinn-Oxid (ITO) oder auch fluordotiertes zinnoxid (FTO) besonders gebräuchlich. Alternativ kann auch eine undotierte zinnoxid Pufferschicht Verwendung finden, welche zusätzlich zur Erhöhung der Leerlaufspannung Uoc beiträgt.

Da die TC0s sehr große Bandlücken besitzen, sind sie auch für sichtbares Licht durchlässig. Da sie darüber hinaus auch noch hoch dotiert sind, wodurch sich ihr Ferminiveau im Leitungsband befindet, wird eine erhöhte metallische Leitfähigkeit erzielt.

TCO wird aufgrund seines sehr hohen Schmelzpunktes und niedrigen Dampfdrucks meist durch Kathodenzerstäubung, das so genannte "Sputtern", abgeschieden.

Als darauffolgende Schicht wird hierauf n-leitendes CdS in einer Dicke von 40 - 300 nm aufgebracht. Diese n-Dotierung wird insbesondere durch einen Cadmiumüberschuss bewirkt.

Zur Abscheidung selbst können verschiedene Methoden lierangezogen werden. Gängig ist die Close-Spaced-Sublimation "CSS" bzw. die chemische Badabscheidung "CBD".

Bei der CBD wird in einer flüssigen Lösung CdS aus der Reaktion zweier metastabiler Prekursoren gewonnen. Im CSS-Prozess wird dann CdS im Vakuum verdampft und auf das heiße Substrat abgeschieden.

Bei diesem Verfahren wird das Substrat auf Temperaturen von um die 500 - 600°C gebracht, bei welchen aber die Revaporation der zu verdampfenden Spezies eine Schichtabscheidung verhindert wird. Um diesen Effekt zu verhindern, wird das Substrat in unmittelbaren Kontakt mit der Quelle gebracht wodurch das Substrat diese Quelle auch von der Umgebung abschließt. Auf diese Weise steht das Substrat in einem thermodynamischen Gleichgewicht mit der Dampfphase von CdS.

Durch den hierbei fast abgeschlossenen Raum können sehr hohe Dampfdrücke und somit ein sehr hoher Teilchenstrom auf die Substratoberfläche hervorgerufen werden, welcher die nicht erwünschte Reevaporation kompensiert.

Dieses Vorgehen ermöglicht nicht nur sehr hohe Substrattemperaturen, sondern auch vergleichsweise hohe Abscheideraten, weshalb es in der kommerziellen Produktion bevorzugt eingesetzt wird.

Die CdTe-Absorberschicht wird ebenfalls mit Hilfe des beschriebenen CSS-Prozess aufgebracht, wodurch eine komplette Schichtdicke von bis zu 8 µm in weniger als zwei Minuten abgeschieden werden kann. Alternativ kann die CdTe-Absorberschicht auch durch Kathodenzerstäubung hergestellt werden.

Vorteile dieses Verfahrens sind sehr homogene und dünne Schichten, eine langsamere Durchsatzzeit, sowie die Tatsache, dass nur eine geringere Substrattemperatur von maximal 300°C benötigt wird und dass besonders dünne Schichten erzeugt werden, können.

Eine vorteilhafte Ausführungsform des CdS/CdTe Dünnschicht-Solar-Moduls besteht darin, dass das transparente leitfähige Oxid eine Stärke von 50 - 200 nm aufweist, darin, dass die n-leitende CdS-Schicht eine Stärke von 40 - 80 nm aufweist und darin, dass die CdTe-Absorberschicht eine Schichtdicke von unter 5 µm aufweist.

Eine weitere vorteilhafte Ausführungsform des CdS/ CdTe- Dünnschicht-Solar-Noduls besteht darin, dass das transparente leitfähige Oxid eine Stärke von 150 -190 nm aufweist, darin dass die n-leitende CdS-Schicht eine Stärke von 50 - 75 nm aufweist und darin, dass die CdTe-Ahsorberschicht eine Schichtdicke von unter 4,5 µm aufweist.

Eine noch weitere vorteilhafte Ausführungsform besteht darin, dass der Rückkontakt aus einem sogenannten primären und einem sogenannten sekundären Kontakt besteht, wobei der primäre Kontakt aus einer tellurreichen Schicht besteht, die durch selektives Ätzen des CdTe-Absorbers mit einer Lösung aus Salpeter- und Phosphorsäure gewinnbar ist. Diese tellurreiche Schicht weist den Vorteil auf, dass sie eine gute p-Leitfähigkeit sicherstellt.

Der sekundäre Kontakt besteht aus einem metallischen Leiter, der die in der Solarzelle erzeugten Löcher abtransportieren hilft. Hierfür wird aufgrund der hohen Austrittsarbeit, der guten Leitfähigkeit und der Langzeitstabilität vorzugsweise-Gold verwendet. Alternativ können jedoch z. B. aus Kostengründen auch andere Metalle, wie molybdän, bzw. Nickel/- vanadium oder Mischungen darvon Anwendung finden.

Alternativ können außerdem Kontakte aus einer kupferhaitigen Graphitpaste aufgebracht werden, was ebenso zu einer deutlichen Verbesserung der Zelleneigenschaften führt, da Kupfer zu einer p-Dotierung des CdTe führt. Ein Nachteil der Verwendung von Kupfer ist jedoch seine eingeschränkte Langzeitstabilität.

Vor der Präparation dieses Rückkontaktes werden die Solarzellen einer Temperaturbehandlung in einer chlorhaltigen Atmosphäre unterzogen, auch "Aktivierung genannt". Durch diese Aktivierung werden die Leistungsmerkmale (VOC, JSC, FF, η) der Solarzelle noch einmal verbessert.

Weitere Ausführungensformen der Erfindung sind nachfolgend anhand der Zeichnung näher erläutert, in dieser zeigen:
Fig. 1 den Aufbau eines CdS/ CdTe Dünnschicht-Moduls;
Fig. 2 den Ablauf der Produktion eines erfindungsgemäßen Dünnschichtmoduls;
Fig. 3 ein Ersatzschaltbild zur Ermittlung der Strom-Spannungskennlinie mit Hilfe eines "Ein-Dioden-Modells";
Fig. 4 die Strom-Spannungs-Kennlinie der Proben A, B, C und D unter simuliertem Sonnenlicht, 1,5 AM und
Fig. 5 das Untersuchungsspektrum (XPS) von Probe B.

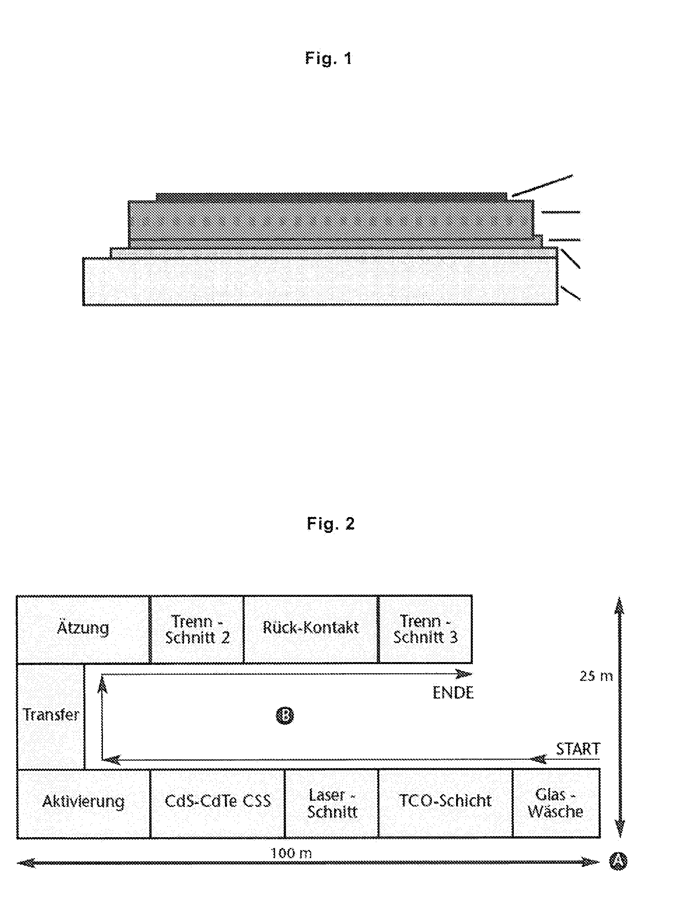

Da es schwierig ist, p-n Dioden in Cadmiumtellurid (CdTe) zu erzeugen und da solche Dioden darüber hinaus eine erhebliche Oberflächenrekombination zeigen, wurde bereits 1971 die heute übliche Zellkonfiguration in Form einer p-n Heterodiode gefunden, in welcher der notwendige p-n Übergang die Form einer Doppelschicht p-CdTe/n-CdS hat. CdS wirkt hierbei als "Fenster", da es vom sichtbaren Licht nur einen kleinen Teil im blauen Spektralbereich absorbiert und den Rest zum aktiven CdTe durchläßt. Dort werden dann die Ladungsträger erzeugt, welche die im Feld des p-n Übergangs getrennt werden und zu einer Photospannung führen. Die Zelle hat den in Fig. 1 wiedergegebenen Aufbau.

Auf einem Substrat, insbesondere einer Glasscheibe 1 wird, wie in Fig. 1 gezeigt, zunächst ein TCO-Film 2 von unter 400 nm, hier von 180 nm (+/- 5 nm) aufgebracht, der so dünn gestaltet wird, wie es technisch möglich ist. Auf diesem Film wird eine n-leitende CdS-Schicht 3 von unter 200 nm, hier von 70 (+/- 5 nm) aufgebracht ist und die auch so dünn gestaltet wird, wie es technisch möglich ist. Auf die Schicht 3 wird eine aktive CdTe-Schicht 4 aufgebracht, die eine Dicke von einigen Mikrometern aufweist und ebenfalls so dünn gestaltet wird, wie es technisch möglich ist, vorliegend mit einer Stärke von etwa 4 µm. Auf diese aktive CdTe-Schicht wird für die Stromabnahme ein Kontakt 5 aufgebracht.

Die Halbleiterschichten CdS und CdTe werden bevorzugt mit einem Sublimationsverfahren hergestellt, das schnell, einfach und robust abläuft und geringe Anforderungen an das verwendete Vakuum stellt. Dieses Verfahren wird "Close Spaced Sublimation" (CSS) genannt.

CdTe-Granulat mit einer Reinheit von 99,999% wird als Ausgangsmaterial hierbei aus einem auf ca. 700°C geheizten Graphittiegel auf die darüber hinweggleitenden Glassubstrate übersublimiert, welche sich auf einer Temperatur von in etwa 500°C befinden, wodurch eine gute Kristallqualität der Schichten gewährleistet wird. CdTe wächst dabei ohne weitere aktive Dotierprozesse p-leitend auf, während CdS n-leitend aufwächst.

Ein spezieller thermischer Aktivierungsprozeß verbessert die elektronische Anpassung des CdS an das CdTe.

Dünnschichtsolarzellen eignen sich besonders gut zur Herstellung von integrierten Modulen, in denen ca. hundert streifenförmige Einzelzellen durch drei Sätze von Trendschnitten auf der Glasplatte definiert und in Serie verbunden werden. Diese Trennschnitte lassen sich zwanglos in den Produktionsprozess integrieren.

Der Produktionsprozess für beispielsweise 60 x 120 cm² große integrierte Module mit 120 verschalteten Einzelzellen umfaßt die folgenden Schritte, gefolgt von einer hermetischen Versiegelung durch Glas/Glas Lamination.

Im Einzelnen werden die in Fig. 2 dargestellten folgenden Schritte 20-28 durchlaufen:
- 20: Glasreinigung,
- 21: Abscheidung des transparente Kontaktfilms durch Kathodenzerstäubung,
- 22: Trennung der TCO Schicht in Streifen durch Laserablation,
- 23: Abscheidung von CdS und CdTe durch CSS,
- 24: Aktivierung (Temperung der CdS/CdTe Doppelschicht in Chlor-baltiger Atmosphäre),
- 25: Chemische Ätzung zur Vorbereitung des Rückkontaktes,
- 26: Trennen der Halbleiterschichten in Streifen,
- 27: Abscheidung des Rückkontaktes durch Kathodenzerstäubung, und
- 28: Trennen der Halbleiter- und Kontaktschichten in Streifen.

Die Anlagen für diese Prozeßsequenz sind in einer Linie zum vollautomatischen Transport der Glasscheiben durch die Einzelprozessstationen in einer nur 30 x 100 m² großen Halle aufbaubar und fugenlos verbindbar. Das Layout einer derartigen Produktionsstraße ist in Fig. 2 dargestellt.

Nach einem zweistündigen Durchlauf werden aus den eingespeisten Glasplatten Dünnschichtmodule. Etwa alle zwei Minuten wird auf diese Weise ein Modul fertiggestellt. In einer zweiten, ähnlich großen Halle werden die Module nach einem Funktionstest mit Metallbändern kontaktiert, durch Auflamination gleichgroßer Glasplatten hermetisch versiegelt, mit Kontaktboxen versehen und bezüglich ihrer photovoltaischen Daten vermessen.

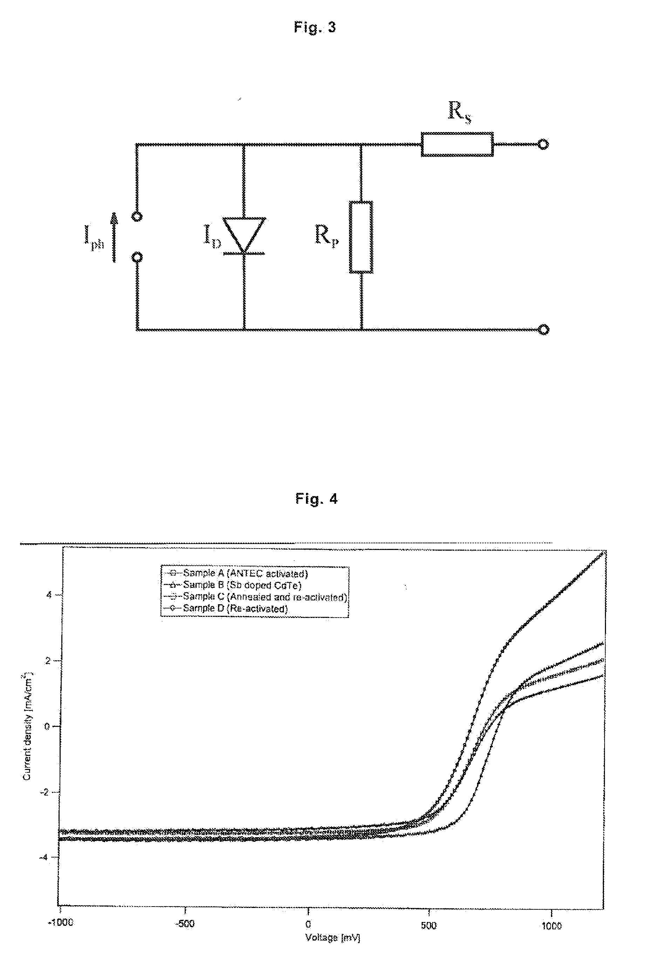

Eine Kennzahl mit hoher Aussagekraft bezüglich der Qualität dieser Module ist das Strom-Spannungsverhalten einer Solarzelle. Das Strom-Spannungsverhalten einer Solarzelle lässt sich am einfachsten durch das so genannte Ersatzschaltbild des "Ein-Dioden-Modells" darstellen, das in Fig. 3 gezeigt ist. Dieses umfasst eine Stromquelle stellvertretend für die photogenerierten Ladungsträger, eine Diode, welche die Eigenschaften des p-n-Kontaktes widerspiegelt und zwei Widerstände RS und RP, welche die Hauptverlustmechanismen zusammenfassen.

Im Serienwiderstand RS ist die Summe aller Schicht-, Kontakt- und Leiterwiderstände zusammengefasst.

Der Parallelwiderstand spiegelt die Oberflächenrekombinationsverluste an den verschiedenen Grenzflächen sowie Verluste durch Leckströme an den Solarzellenkanten und an leitfähigen Pfaden innerhalb der Zelle wider.

In einer idealen Solarzelle gilt RS=0 und RP=∞. In realen Solarzellen führen nichtideale Widerstände zu einer Verschlechterung des Füllfaktor und damit zu einer Verringerung des Wirkungsgrades.

Um die Auswirkung von Sb, welches dem CdTe hinzugefügt wird, auf die Leistung von Solarzellen zu testen, wurden vier identische aktivierte Solarzellen (Glas/ITO/Sn02/CdA/CdTE ohne Rückkontakt) verwendet. Diese Zellen wurden demselben Modul entnommen.

Eine Probe A wurde per standardisiertem Ätzprozess (25 Sekunden) und anschließendem gesputtertem Rückkontakt vervollständigt.

Eine Probe B wurde wie folgt behandelt:
Spülen mit entionisiertem Wasser und Trocknen;
Aufbringung eines dünnen Sb-Films (ca 2nm) auf der CdTe-Schicht durch thermische Verdampfung- bei Raumtemperatur; Tempern in Argonatmosphäre bei 380°C (Dauer: 60 Minuten); Reaktivierung (ex-situ-Aktivierung, nasse CdC12 Abscheidung und Luft-Tempern bei 400°C (Dauer: 20 Minuten);
Spülen mit entionisiertem Wasser und Trocknen;
Chemische Ätzung (25 Sekunden);
Spülen mit entionisiertem Wasser und Trocknen; und
Aufbringen des Rückkontakts (-100 nm gesputtertes Gold).

Eine Probe C wurde wie die Probe B behandelt, jedoch wurde keine Schicht Sb auf das CdTe aufgebracht.

Eine Probe D wurde aus per Ex-Situ Prozess aus einer Antec-Zelle reaktiviert und durch Waschung, Ätzung und Aufbringen eines goldgesputterten Rückkontakts ergänzt.

Um den Effekt der zusätzlichen Sb-Schicht zu festzustellen, wurden die Proben C und D ebenfalls reaktiviert. Es wurde jedoch keine Sb-Schicht aufgedampft.

Die Ergebnisse der Probennahmen sind in Fig. 4 dargestellt, die eine Strom-Spannungs-Kennlinie der Proben A, B, C und D unter simuliertem Sonnenlicht, bei 1,5 AM bei 100 mW/cm2 (wie STC) zeigt.

Um diese Zellen miteinander vergleichen zu können, wurden die Voc, der Kurzschlussstrom (Jsc), Füllfaktor und die Leistung in der Übersicht der Tabelle 1 zusammengestellt. Dieser ist entnehmbar, dass die Probe A einen eher geringen Voc besitzt. Bei einer nach den erfindungsgemäßen Kriterien aktivierten Antec-zelle, stiegen die Leerlaufspannung, der Füllfaktor und die Effizienz auf bis zu 11,7%.

Vergleicht man die Proben B, C und D, kommt man zu dem Schluss, dass diese Erhöhung des Wirkungsgrades auf den erfindungsgemäßen Aktivierungsprczess und die erfindungsgemäße Aufbringung von Sb auf CdTe zurückzuführen ist.

**Tabelle 1: Vergleich einer unbehandelten (Probe A) und behandelten Antec-zeilen:**

| | V,,,, [mV] | Js, [mA/cm2] | Fill factor | Efficiency [%] |
|---|---|---|---|---|
| Sample A (Antec activated) | 0.66 | 22.7 | 57.4 | 8.7 |
| Sample B (Sb doped CdTe) | 0.77 | 23 | 65.8 | 11.7 |
| Sample C (Annealed in Ar and re-activated) | 0.73 | 21.7 | 62 | 9.3 |
| Sample D (Re-activated) | 0.73 | 21 | 59.6 | 9.1 |

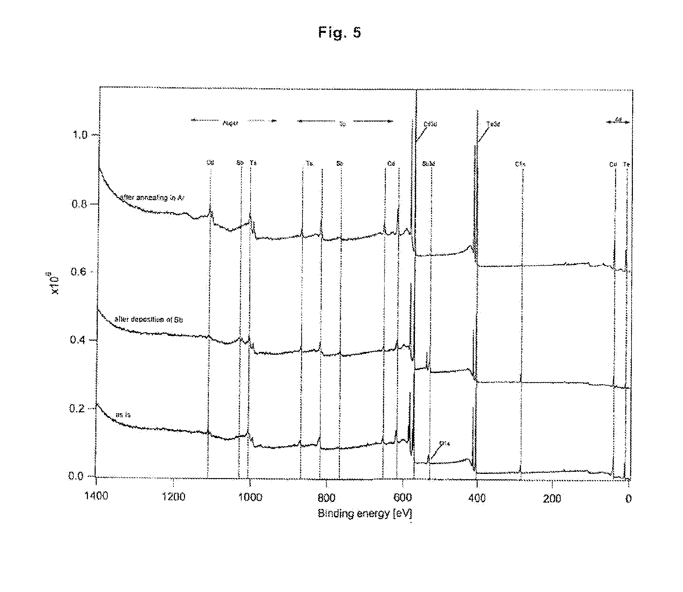

In Fig.5 ist das untersuchungsspektrum (XPS) der Probe B vor der Aufbringung der Sb-Schicht, nach der Aufbringung der Sb-Schicht und nach Tempern dargestellt. Es ergibt sich, dass nach dem Tempern nur eine äußerst geringe Menge Sb auf der CdTE Oberfläche verbleibt. Während des Temperprozesses diffundiert der überwiegende Teil von Sb in die CdTe.Schicht und erhöht deren p-Dotierung. Darüber hinaus ist Fig. 5 entnehmbar, dass die Anzahl an Sb-Atomen, die aus der CdTE Oberfläche bei einer Temperatur von 380°C und einem Druck von 5x10 (-2) mbar und bei einem Restdampfdruck von Sb bei 425°C bei 1*10 (-4) mbar verdunsten, vernachlässigbar ist. In der der Fig. 5 zugrunde liegenden Untersuchungsreihe wurden aktivierte Antec-Proben benutzt.

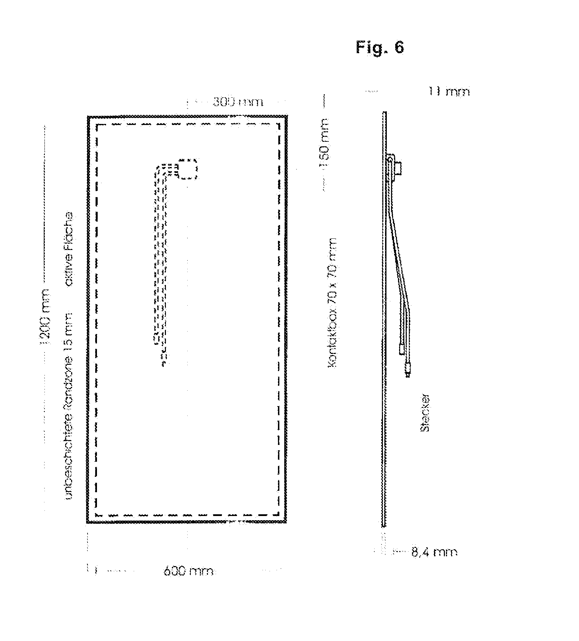

Fig. 6 zeigt beispielhaft ein erfindungsgemäß hergestelltes Dunnschicht-Solarmodul ATF 50. Hierbei handelt es sich um ein industriell gefertigtes Solarmodul zwischen zwei Glasscheiben von je 4 mm laminiert rohstoffschonender siliziumfreier Dünnschicht-Technik. Es umfasst besonders stabile Halbleiterschichten aus CdTe und erscheint in einer rahmenlosen, schwarsgrünen Optik.

Die energetische Amortisationszeit dieses Moduls beträgt weniger als ein Jahr. Das Modul zeichnet sich aufgrund der dargestellten erfindungsgemäßen Maßnahmen durch einen geringen Leistungs-Temperatur-Koeffizienten von nur - 0,18% / °Celsius aus. Darüberhinaus weist es aufgrund der dargestellten erfindungsgemäßen Maßnahmen ein hervorragendes Schwachlichtverhalten auf sowie hieraus resultierend einen hohen Jahresenergieertrag.

Weitere technische Daten sind der folgenden Tabelle 2 entnehmbar:

| **Technische Daten zum Dünnschichtmodul ATF 50** | | | |
|---|---|---|---|
| Nennleislung Pₘₐₓ: | 50 Wp ±10% | Modulaufbau: | Glas-Felie-Glas |
| Anzahl der Zellen in Reine: | 118 | Anschlusbox: | Telegartner |
| Zellart | Dunnschicht | Kabel: | MC; 2.5 mm²; B60 mm bzw 760 mm |
| | (CdS / CdTe) | Stecker/ Buchsen: | MC: PV-KST 411 /PV-KBT 41/ |
| Nennstrom Iₒₚₐ: | 0,89 A | Frontseite: | Flachglas 4 mm |
| Nennspannung Uᵤₚₚ: | 56,0 V | | |
| Kurzsehtusstrom I_{uc}: | 1,11 A | Rahmen: | rahmenlos |
| Leerlaufspannung U_{oc}: | 85,0 V | | |
| Max. zulässige Spannung: | 1,000 V | Hagelsicherheit: | getestet mit 25 mm Eiskugein bei |
| Temperaturkoeffizient T_{K} (Pₘₐₓ). | -0,18% /°C | | 23 m/s (entspricht IEC 61646) |
| Tamperalurkoeffizient T_{K} (U_{oc}): | -0,25% / °C | Zertifikate: | IEC 61646 (beantragl) |
| Temperalurkoetlizient T_{K} (I_{sc}): | +0,08% /°C | | Schutzklasse II |
| Betriebstemperatur: | -40 bis +85°C | | |
| Druckbelastung: | 2.400 Pa | Leistungsgarantie: | 20 Jahre (80% der Ausgangsleislung) |
| Verwindung: | 1,2° | *(sieche weiterhin:* | ANTEC Solar Energy international AG |
| MaBe L x B x H: | 1200 x 600 x 8,4 mm | *Garantiebedingungen* & | Emil-Paßburg Str. 1 |
| Tiefe mit Anschlussbox: | 11 mm | *installationshinweise*) | 99310 Arnstadt |
| Gesamtdicke: ca. 20 mm | ca.20 mm | | www.armec-solar.de |
| Gewicht: | 16 kg | | |

## Patentansprüche

1. Cds/CdTe Dünnschicht-Solar-Modul, umfassend auf einer Trägerplatte eine transparente leitfähigen Oxidschicht (TCO), auf dieser TCO-schiclit eine n-leitende CdS-Schicht, auf dieser n-leitenden CdS-Schicht eine CdTe-Absorberschicht, wobei die transparente Leitfähige Oxidschicht eine Stärke von unter 400 nm aufweist, wobei die n-leitende Cds-Schicht eine Stärke von unter 200 nm aufweist, und wobei die CdTe-Absorberschicht eine Schichtdicke von unter 7 µm aufweist und Antimon enthält.

2. CdS/CdTe Dünnschicht-Solar-Modul nach Anspruch 1, wobei die transparente leitfähige Oxidschicht eine Stärke von 50-200 nm aufweist, wobei die n-leitendes CdS-Schicht eine Stärke von 40 - 80 nm aufweist, und wobei die CdTe-Absorberschicht eine Schichtdicke von unter 5 µm aufweist.

3. Cds/CdTe Dünnschcht-Solar-Modul nach Anspruch 1 oder 2, wobei das transparente leitfähige Oxidschicht eine Stärke von 150-190 nm aufweist, wobei die n-leitende CdS-Schicht eine Stärke von 50 - 75 nm aufweist, und wobei die CdTe-Absorberschicht eine Schichtdicke von unter 3,5 m - 4,5 µm aufweist.

4. CdS/CdTe Dünnschicht-Solar-Modul nach einem der vorhergehenden Ansprüche, wobei der Rückkontakt aus einem sogenannten primären und einem sekundären Kontakt bestehen, wobei der primäre Kontakt aus einer tellurreichen Schicht besteht.
